# EUROPÄISCHE PATENTSCHRIFT

(11) **EP 1 324 850 B1**
(45) Veröffentlichungstag und Bekanntmachung des Hinweises auf die Patenterteilung: **18.05.2005**
(21) Anmeldenummer: 01986282.0
(22) Anmeldetag: 05.10.2001
(51) Int. Cl.: B23K 1/018, H05K 3/00

(54) **ABTRAGEN VON KONTAKTSTELLEN (DE-BUMPING)**
METHOD FOR ABLATING POINTS OF CONTACT (DEBUMPING)
PROCEDE D'ELIMINATION DE POINTS DE CONTACT (SUPPRESSION DE BOSSAGES)

(30) Priorität: 06.10.2000 DE 10049664
(43) Veröffentlichungstag der Anmeldung: 09.07.2003
(73) Patentinhaber: Pac Tech - Packaging Technologies GmbH, 14641 Nauen (DE)
(72) Erfinder: TEUTSCH, Thorsten, Am Schlangenhorst 15-17 14641 Nauen (DE); ZAKEL, Elke, 14612 Falkensee (DE)
(74) Vertreter: Leonhard, Frank Reimund, Dipl.-Ing.
(86) Internationale Anmeldenummer: PCT/DE2001/003833
(87) Internationale Veröffentlichungsnummer: WO 2002/028585

(56) Entgegenhaltungen:
- WO-A-88/07317
- US-A- 3 210 182
- US-A- 3 684 151
- US-A- 4 216 035
- US-A- 4 942 997

## Beschreibung

Die Erfindung betrifft ein Verfahren zum Abtragen einer Vielzahl von erhabenen Kontaktstellen aus - oberhalb einer ersten Temperaturgrenze - schmelzfähigem Metall, wie Zinn oder Indium, oder einer solchen Legierung, wie zinnhaltiges Lot, siberhaltiges Lot oder bleihaltiges Lot, welche Kontaktstellen auf einem Substrat flächig verteilt angeordnet sind.

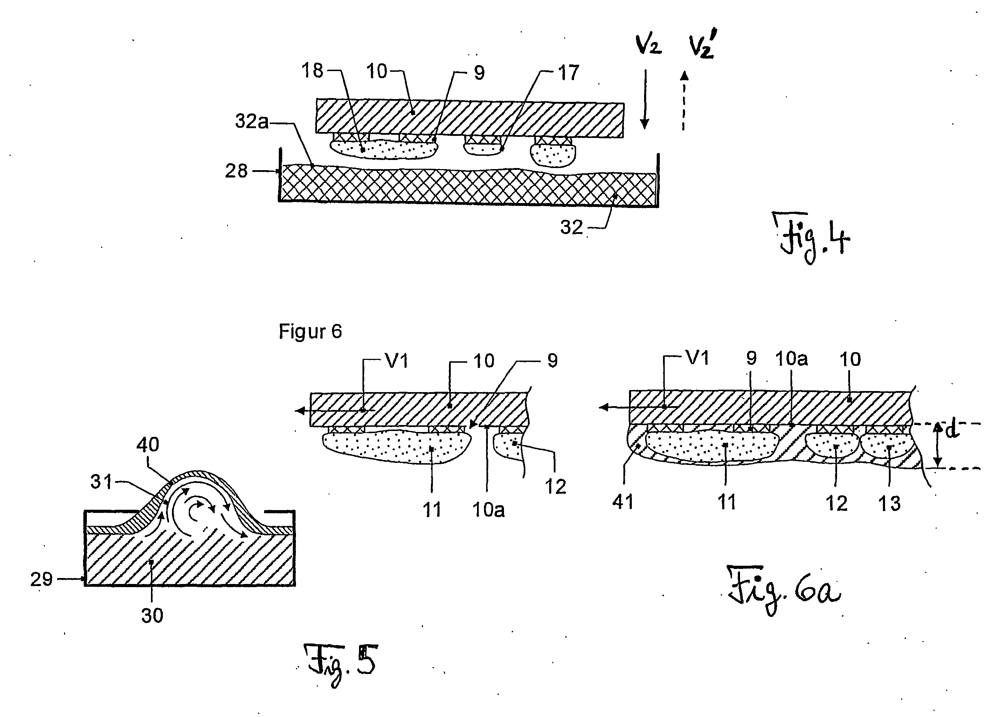

Zur Verdeutlichung **der Problemstellung** der Erfindung mag angesprochen sein, daß nicht nur flache leitfähige Hauben erhabene Kontaktstellen ergeben - es wird auch von "Menisken" gesprochen, die auf metallische Trägersegmente aufgetragen werden -, sondern stärkere erhabenen metallische Strukturen auf metallische Trägersegmente aufgetragen sein können, die als Lotkugeln oder Kontaktbumps für eine Flip-Chip-Kontaktierung Verwendung finden, vgl. dazu die Veröffentlichung "Semiautomatic Solder Ball Bumper (SB²) von Pac Tech und die Veröffentlichungen "Solder Ball Bumper (SB²) - A flexible manufacturing tool for 3-dimensional sensor and microsystem packages", Kasulke, Schmidt, Titerle, Bohnaker, Oppert, Zakel, veröffentlicht in IEMT Europe 1998, dort Figur 6 und Figur 8 im Querschnitt. Diese erhabenen Kontaktstellen werden in mehreren verschiedenen Verfahren hergestellt, beispielsweise durch Laser oder durch Umformen in einem Ofen, nach vorhergehendem Auftragen eines Drucks von kleineren Lotpartikeln, die im Ofen zu den beschriebenen erhabenen Kontaktstellen in Form von Kugeln umgeschmolzen werden. Ihre Höhe ist zumeist wesentlich höher, als diejenige der metallischen Trägersegmente, die auf dem Substrat verteilt angeordnet sind. Die nie ganz zu vermeidende Wahrscheinlichkeit der Bildung von metallischen Brücken durch Herüberfließen von Lotkugeln zu anderen Lotkugeln, veranlaßt durch zu dicke Flußmittelschichten, oder aber das Fehlen von einzelnen Lotkugeln allgemein, macht die Verwendung des Substrates technisch unmöglich, weil dann bestimmte Kontaktstellen entweder nicht kontaktiert werden, oder bereits vor der Kontaktierung einen Kurzschluß aufweisen.

Eine weitere fehlerhafte Kontaktierung kann auch dadurch erfolgen, daß eine zu große Menge des die Kontakthöcker bildenden Lotes auf das Substrat aufgetragen wurde und deshalb eine Unsymmetrie der gebildeten erhabenen Kontaktstellen entsteht, die sowohl in der Höhe, wie auch in der lateralen Erstreckung Unsymmetrien aufweisen können, ebenso wie die zuvor beschriebenen Fehlstellen an bestimmten, meist einzelnen metallischen Trägersegmenten.

Die Substrate sind dabei besonders bei Ausbildung als Wafer zumeist zu wertvoll, um dem ganzen Substrat seine Verwendung zu versagen, wenn einzelne Stellen bei der Kontaktierungs-Vorbereitung durch Aufbringen der erhabenen Kontaktstellen beschädigt sind. Es muß deshalb eine kostengünstige Lösung gefunden werden, diese beim Kontaktieren schadhaft gewordenen kontaktierten Substrate zu reparieren, wozu im Stand der Technik auch schon eine spezifische Lösung vorgeschlagen wurde, namentlich **das individuelle Reparieren** einzelner Kontaktstellen als SBB Repair Station, vgl. vorgenannte Schrift "Solder Ball Bumper (SB²)", dort Figur 10 mit zugehöriger Beschreibung. Ein einzelner Laserimpuls wird dazu verwendet, um ein Reflow der schadhaften Kontaktstelle zu erreichen und mit einem Vakuum die umgeschmolzene und erweichte Lotkugel abzuziehen. Gleichzeitig wird eine Stickstoffatmosphäre eingesetzt, um eine Oxidation der verbleibenden Lotkappe auf dem flächig begrenzten Trägersegment zu vermeiden.

Der Erfindung liegt die **technische Problemstellung** zugrunde, eine kostengünstigere Herstellung zu ermöglichen, insbesondere einen einmal erfolgten Lotauftrag auf einem Substrat rückgängig machen zu können, wenn Fehlerstellen auftreten, bei denen große erhabene Kontaktstellen nicht an denjenigen Orten der metallischen Trägersegmente (selektiv) plaziert sind, sondern unter Brückenbildung eine Kontaktstruktur ergeben, die einen ordnungsgemäßen Einsatz des Substrates, beispielsweise als kontaktierter Wafer, nicht mehr erlauben.

Erfindungsgemäß wird die erstgenannte Aufgabe, auch die zweitgenannte Aufgabe durch Anspruch 1 gelöst.

Erfindungsgemäß ist es möglich, mehrere Kontaktstellen zusammen so zu reparieren, daß zumindest der wesentliche Bestandteil der einzelnen Kontaktstellen durch ein Abschmelzen abgetragen wird, wobei die Abschmelzung in einem geschmolzenen Metall stattfindet (Anspruch 1) und keine einzelnen Kontaktstellen individuell und in zeitlicher Abfolge durch lokales Erhitzen abgetragen werden müssen.

Mit der Erfindung wird dabei das Substrat und alle Kontaktstellen mit dem geschmolzenen Metall in Verbindung gebracht, um kostengünstig und mit wenig Zeitaufwand die gesamte Vorkontaktierung wieder zu entfernen, von einem neuen Status quo auszugehen und das Substrat erneut mit erhabenen Kontaktstellen zu beschichten. Diese Art der Reparatur ist eine Beseitigung der vorhergehenden Kontaktierung, verbunden mit der Möglichkeit, die Neukontaktierung in einem Zustand zu beginnen, bei dem alle weiterhin vorhandenen metallischen Trägersegmente gleich gestaltet sind. Das betrifft sowohl diejenigen Kontaktstellen, bei denen eine Kontaktierung durch eine erhabenen Lotkugel nicht erfolgte, wie auch diejenigen Kontaktstellen, die mit zumindest einer weiteren Kontaktstelle einen Kurzschluß durch eine ungenau plazierte Lotkugel erfahren.

Durch das Abschmelzen wird das Lot der erhabenen Kontaktstelle von dem geschmolzenen Metall aufgenommen. Die auf den Trägersegmenten verbleibenden Hauben geringer Höhe erhalten im wesentlichen dasjenige Metall oder diejenige Metall-Legierung, aus der das geschmolzene Metall besteht. Diese Möglichkeit erlaubt es gleichzeitig, fehlerhaft kontaktierte Substrate ebenfalls zu reparieren, durch Austausch des ersten Lotes, das bereits erstarrt ist, und Ersetzen dieses Lotes mit dem Lot entsprechend dem geschmolzenen Metall, insbesondere der geschmolzenen Metall-Legierung, die sich in dem Bad befindet.

Sind die beiden Metalle, insbesondere die beiden Metall-Legierungen, gleich, also das Metall der erhabenen Kontaktstellen und das Metall des geschmolzenen Bades, so erfolgt nur ein Abtrag und kein Austausch der Stoffe. Zumindest die wesentlichen Bestandteile der schon erstarrten erhabenen Kontaktstellen auf dem Substrat werden aber abgetragen, bei einem Verbleib der beschriebenen Hauben als "Menisken" geringer Höhe.

Ergänzend kann beispielsweise auf das Substrat nur eine Deckschicht eines organischen Fluids aufgebracht werden, welche Deckschicht als Film eine gegenüber dem Substrat geringe Dicke besitzt. Aufgrund der geringen Dicke dieser Fluidschicht (Anspruch 19 spricht von einer dünnen Schicht) verdampft diese Schicht nach der Berührung mit dem flüssigen Metall aufgrund des Dampfdruckes, so daß ein sich anschließender Reinigungsschritt der nach Abtragen der Vorkontaktierung erneut beschichteten Trägersegmente und des zugehörigen Substrates entfällt. Die Reparatur wird kostengünstiger. Es wird wesentlich weniger Volumen des insbesondere als Polyalkohol, wie Glyzerin, zum Einsatz kommenden Fluids verwendet, das nach dem beschriebenen Prozeß verdampft ist. Generell vermeidet die Erfindung das Verwenden eines Bades von erheblichem Volumen mit Bezug auf das beschriebene Fluid.

Die erste Temperaturgrenze des Anspruchs 1 ist so zu verstehen, daß ein schmelzfähiges Metall abgetragen werden soll, das Substrat aber nicht geschmolzen werden soll. Die erhabenen Kontaktstellen, zumeist aus Lot bestehend, sind bei Temperaturen unter 200°C (zumeist unter 250°C) schmelzfähig. Das verwendete organische Fluid hat bei Verwendung von Glyzerin eine Siedetemperatur von 290°C. Ähnliche oder vergleichbare Stoffe sollten eine Siedetemperatur oberhalb von 250°C besitzen. Ist das geschmolzene Bad aus demselben Metall (insbesondere als Metall-Legierung) gestaltet, bezieht sich die erste Temperaturgrenze auch auf dieses Metall, das demgemäß auch zumindest an oder oberhalb dieser Temperaturgrenze liegen sollte, um das Abschmelzen und das Aufnehmen der erhabenen Kontaktstellen von dem Substrat zu ermöglichen.

Die verteilte Anordnung der beschriebenen erhabenen Kontaktstellen oder der sie tragenden metallischen Trägersegmente (Anspruch 2) betrifft eine großflächige Verteilung dieser Grundkontaktierung, die ihrerseits jeweils auf einem metallischen Grundpad aufgetragen sind, das die Kontaktierung zu den Leiterbahnen des Substrates bei Ausbildung als Wafer ermöglicht. Die großflächige Verteilung ist Ansatzpunkt für die Erfindung, ein großflächiges Abtragen durch Abschmelzen von dem Substrat vorzuschlagen.

Erfindungsgemäß ist es möglich, die erhabenen Kontaktstellen entweder praktisch vollständig abzutragen, oder vollständig abzutragen und ihre stoffliche Beschaffenheit dabei auszutauschen.

Als Substrat können die Substrate Anwendung finden, die auch im Stand der Technik beschrieben sind, z.B. Wafer, Leiterplatten oder Keramiksubstrate.

Soweit im folgenden von einem Metall gesprochen wird, ist immer auch eine Metall-Legierung angesprochen. Das hat sowohl für die erhabenen Kontaktstellen Geltung, wie auch für das geschmolzene Metall in dem Bad. Als Bad kann sowohl eine ruhende Schmelze Verwendung finden (Anspruch 8), die durch eine Relativbewegung mit den abzutragenden Kontakthöckem in Verbindung gebracht wird, wie auch eine zumindest teilweise in Bewegung befindliche Schmelze (Anspruch 11), auf welche das Substrat mit den abzutragenden erhabenen Kontaktstellen hin bewegt wird. Ein Absenken in vertikaler Richtung (Anspruch 9) entspricht einem flächigen Abtrag aller Kontakthöcker praktisch zeitgleich. Eine Relativbewegung in horizontaler Richtung, bei der das Substrat auf das schwallförmig vertikal hervorstehende Metallbad hinbewegt wird, entspricht einem streifenförmigen Abtragen der erhabenen Kontaktstellen zeitlich nacheinander, aber über die gesamte Fläche gesehen gleichmäßig (Anspruch 12).

Die Verweilzeit bei einem zumindest berührenden Eintauchen oder bei einem Herüberbewegen ist jeweils so bemessen, daß eine ausreichende Zeit zur Verfügung steht, die erhabenen Kontaktstellen abzuschmelzen und den verbleibenden Haubenauftrag auf den Trägersegmenten zu belassen oder überhaupt zu schaffen.

Die erfindungsgemäß gewählte dünne Schicht des Mediums verdampft von der Substratoberfläche während der Berührung mit der Metallschmelze praktisch rückstandsfrei (Anspruch 14). Das Auftragen dieses Films kann durch Aufsprühen oder durch eine dampfförmige Atmosphäre im Sinne von Aufdampfen geschehen (Anspruch 15). Sind vor dem Berühren des flüssigen Metalls die Trägersegmente bereits mit erhabenen Kontaktstellen aus abschmelzbarem Metall versehen, kommt der Film als dünne Fluidschicht zwischen dem Substrat sowie den dort verteilt angeordneten Trägersegmenten zu liegen.

Der dampfförmige Auftrag auf das Substrat kann gleichzeitig mit dem Berühren des Metallbades erfolgen die Atmosphäre kann sich aber auch so weit vor die Metallschmelze erstrecken, daß ein Durchlaufen oder ein Hindurchbewegen des Substrates mit den Trägersegementen durch diese Atmosphäre für den dünnen, filmartigen Auftrag des organischen Fluids sorgt.

Das organische Fluid kann denselben Bedingungen genügen, wie auch aus denselben Stoffen gestaltet sein, wie in der **eP 781 186 B1** erläutert.

Die Erfindung wird nachfolgend anhand von **Beispielen** erläutert und ergänzt.
- **Figur 1**: ist eine Schnittdarstellung eines Substrats mit ordnungsgemäß aufgebrachten erhabenen Kontaktstellen, bestehend aus einer ersten Metallisierung 9 und einer darauf gebildeten, im wesentlichen kugelförmigen erhabenen Kontaktstruktur 25.
- Figur 2: ist ein Schnitt eines fehlerhaft entstandenen Substrates 10 mit ungleichmäßigen Kontaktstrukturen entsprechend den nicht regelmäßig ausgebildeten und nicht kugelförmig gestalteten Kontakthöckern 11, 12, 13, 14.
- Figur 3: ist eine Schnittdarstellung eines Substrates mit metallischen Trägersegmenten 9 gemäß den Figuren 1,2 und darauf angebrachten haubenförmigen Menisken 60, wie sie nach einem Abschmelzverfahren entstehen.
- **Figur 4**: ist eine erste Darstellung eines Abschmelzverfahrens, bei dem das Substrat 10 mit fehlerhaft gebildeten Kontaktstellen 17,18 in ein flüssiges Bad aus einer Metallschmelze 32 abgesenkt wird.
- **Figur 5**: ist eine Darstellung eines zweiten Metallbades, bei dem ein Schwall 31 streifenförmig ausgebildet wird.
- **Figur 6**: ist eine Kopfüber-Darstellung eines Substrates 10, bei dem fehlerhaft ausgebildete Kontakthöcker 11,12 entlang der horizontalen Bewegung v1 zu dem Schwallbad von Figur 5 hin bewegt werden, wobei die Figuren 5 und 6 zueinander räumlich koordiniert sind.
- **Figur 7**: ist eine zu Figur 5 alternative Darstellung der Bewegung eines Substrates zu einem Schwallbad als bewegte Metallschmelze 30, wobei eine die gleichförmige Abschmelzung begünstigende Atmosphäre 50 von einer vertikalen Ebene 51 an vorgesehen ist.
- **Figur 8**: repräsentiert ein zu Figur 4 alternatives Verfahren, bei dem eine filmähnliche Beschichtung eines organischen Fluids auf die erhabenen Kontaktstellen und das Substrat aufgesprüht wird, bevor es in einer Kombination aus horizontaler Bewegung v1 und vertikaler Bewegung v2 in ein unbewegtes Bad 32 abgesenkt wird.

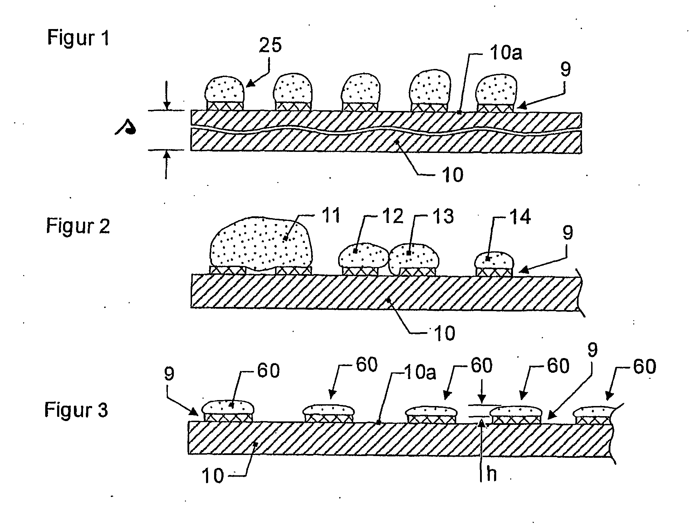

Die **Figuren 1 und 2** veranschaulichen in direkter Gegenüberstellung ein Substrat 10, das ein Wafer oder eine Leiterplatte sein kann. Bei der Darstellung gemäß Figur 1 ist ersichtlich, daß die Kontaktstellen 25, zumeist Kontaktbumps genannt, die aus einem schmelzfähigen Lotmaterial bestehen, das bei einer Schmelztemperatur von 183°C schmilzt, regelmäßig ausgebildet sind. Sie sind jeweils angeordnet auf einer UBM-Metallisierung (underbump metalization), die eine segmentierte Zwischen-Metallisierung 9 aus Nickel mit beispielsweise Goldüberzug ist, um eine Diffusionssperre zu den eigentlichen Bondpads auf dem Substrat 10 zu erhalten, die zumeist aus Aluminium gefertigt sind. Die Größenverhältnisse sind nicht maßstäblich dargestellt, es sind nur schematische Darstellungen, zur Veranschaulichung des Verfahrens und zur vergrößerten Darstellung von Unsymmetrien in den Kontaktgeometrien, wie sie in Figur 2 gezeigt sind.

Aus Figur 1 kann entnommen werden, daß die Oberfläche des Substrates 10 mit 10a bezeichnet ist. Die Stärke (oder Dicke) des Substrates ist s. Sie liegt bei Wafem in der Größenordnung oberhalb 500µm, während die Nickel-Zwischenträger 9, die als UBM vorgesehen sind, in der Größenordnung zwischen 5µm und 10µm hinsichtlich ihrer Höhe sind. Diese metallischen Trägersegmente sind in ihrer jeweiligen Fläche wesentlich kleiner als die Oberfläche 10a des Substrates 10. Der Abstand, der zwischen zwei solcher begrenzten Trägersegmente 9 vorzusehen ist, entspricht zumindest der doppelten Höhe der normalerweise und ordnungsgemäß aufgebrachten Kontaktstrukturen 25 aus Figur 1.

Die Fehlerstellen aus Figur 2 können folgendermaßen erläutert werden. Zwischen den linken beiden Zwischenmetallisierungen ist ein vergrößerter Kontaktbump 11 ersichtlich, der als übererhabener Kontakthöcker aus einem Zusammenschmelzen von zwei benachbarten Kontakthöckem entstanden ist. Eine solche innere Kurzschlußbildung zwischen zwei an sich zu isolierenden Kontakthöckern entsteht im Herstellungsverfahren der Kontaktbumps zuweilen dann, wenn zu große Mengen eines Lotes beispielsweise durch Siebdruck aufgebracht werden, oder wenn eine zu starke Schichtdicke eines Flußmittels aufgebracht wird, die bei einem Nachschmelzen (einem Reflow-Prozeß) in einem Ofen benötigt wird, um die kleineren Komstrukturen eines aufgebrachten vorläufigen Kontakthöckers zu einem kugelförmigen Kontakthöcker mit glatter Oberfläche umzuformen. Eine ähnliche Kontaktbildung zwischen zwei Kontakthöckem 12 und 13 ist bei den nächsten beiden Kontaktsegmenten 9 gezeigt, hier allerdings mit einer kleineren Ausbildung der Höhe der Kontaktbumps. Es findet nur eine Verlagerung und eine Brückenbildung statt. Ein etwas zu gering in seiner Höhe ausgestalteter Kontakthöcker 14 ist auf der weiteren Zwischenmetallisierung 9 angeordnet. Eine nicht dargestellte Variante eines Fehlers ist ein Fehlen eines Kontakthöckers auf einem dann leeren Zwischenträger 9. Eine ebenfalls nicht dargestellte Variante ist das versehentliche Auftragen eines falschen Lotes als Metallhöcker auf der gesamten Oberfläche des Substrates 10, die selbst dann unerwünscht wäre, wenn die kugelförmige Struktur 25 der Figur 1 bei sämtlichen Kontakthöckem des Substrates 10 erzielt worden wäre.

Ist ein Substrat 10 ein Wafer, ist sein Wert höher als derjenige Wert, der für ein kostengünstiges Verfahren aufgewendet werden muß, diesen Wafer hinsichtlich seiner Kontaktstrukturen zu reparieren, also die fehlerhaften Kontakthöcker herauszunehmen und durch ordnungsgemäße Kontakthöcker 25 zu ersetzen.

Die übrigen Figuren zeigen, wie eine solche Vereinheitlichung auf der Oberfläche eines Substrates 10 erreicht werden kann. Dazu sei zunächst auf die **Figur 4** verwiesen. In Figur 4 ist das Substrat 10 mit den dort gezeigten unsymmetrischen Kontakthöckern 17,18 versehen. Der noch tolerierbare Kontakthöcker neben dem Kontakthöcker 17 könnte zwar belassen werden, aber das Beispiels des Verfahrens geht davon aus, daß bei einem Absenken in Richtung v2 in vertikaler Richtung, ein gesamtes Abschmelzen sämtlicher Kontakthöcker vorgenommen wird, wobei unter dem Substrat 10 eine Wanne 28 mit einem darin ausgebildeten Metallbad 32 vorgesehen ist, dessen Oberfläche 32a zu den abzuschmelzenden Kontakthöckem 17,18 ausgerichtet ist.

Die beschriebene Relativbewegung v2 kann auch so erfolgen, daß das Substrat steht und die Wanne 28 auf das Substrat zu bewegt wird. Bei einer relativen Absenkbewegung wird das Substrat 10 gegenüber der Oberfläche 32a soweit abgesenkt, daß zumindest die flächig begrenzten Trägersegmente 9 die Oberfläche 32a berühren und der gesamte über die Trägersegmente nach unten sich erstreckende Bereich von fehlerhaft aufgetragenen Kontakthöckern, wie auch derjenige von ordnungsgemäß aufgetragenen Kontakthöckem - im Bild sind nur die fehlerhaften dargestellt, bei im übrigen regelmäßigen Kontakthöckem gemäß Figur 1 - vollständig abgetragen wird und von dem Bad 32 aufgenommen wird.

Die Zeitdauer, die das Substrat 10 an die Oberfläche 32a angenähert ist, sollte so dimensioniert sein, daß ausreichend Zeit bleibt, die Kontakthöcker 18,17 abzuschmelzen und die Trägersegmente 9 zumindest insoweit zu erwärmen, daß sie in ihrer Oberfläche durchgehend zumindest die Schmelztemperatur des Lotes der Kontakthöcker besitzen. Dann wird ein gleichmäßiges Abschmelzen der Kontakthöcker erzielt, und es ergibt sich nach Herausnehmen in Richtung v2' und Wenden des Substrates 10 die Struktur gemäß Figur 3.

In **Figur 3** ist eine als solches bekannte Struktur gezeigt, bei der die einzelnen Zwischenträger 9 jeweils haubenförmige Menisken 60 tragen, die in einem spitzen Winkel ausgehend vom Rand des jeweiligen flächig begrenzten Trägers 9 eine Wölbung bilden, die aufgrund der Oberflächenspannung des auf den Trägem verbleibenden Lotes entsteht. Die Höhe der Hauben 60 ist mit h bezeichnet, und sie ist wesentlich geringer als die ordnungsgemäße Höhe der Kontaktstrukturen 25 von Figur 1, aber im wesentlichen in der Größenordnung der Höhe der Zwischenmetallisierung 9, die als UBM-Metallisierung auch im Stand der Technik bekannt ist. Das Substrat 10 ist ebenso wie die metallischen Zwischenträger 9 strukturell unverändert, nachdem ihre Schmelztemperaturen oberhalb derjenigen Temperatur liegt, die das Metallbad 32 an geschmolzenem Metall besitzt.

Es ist anzumerken, daß das geschmolzene Metall zumeist eine Legierung sein wird, die sich für eine "Belotung" von Nickel eignet und hinsichtlich des Widerstandes für Kontaktstrukturen geeignet ist. Es werden hierbei Zinn oder Legierungen von Zinn eingesetzt, ebenso wie Silberlegierung oder Indium-Legierungen.

Das Bad 32 kann dieselbe stoffliche Beschaffenheit besitzen wie die abzuschmelzenden Kontakthöcker. Sind die Kontakthöcker aber versehentlich aus einem falschen Stoff gebildet worden, so dient das Bad 32 nicht nur dem Abschmelzen der Kontakthöcker, sondern auch dem Austausch der Menisken 60 aus Figur 3, die nach der Behandlung gemäß Figur 4 jetzt die stoffliche Beschaffenheit besitzen, die das Bad 32 vorgibt.

Die Differenz zwischen der Volumenmenge eines Meniskus 60 und der Volumenmenge eines entweder ordnungsgemäß oder fehlerhaft aufgetragenen Kontakthöckers gemäß Figur 1 oder Figur 2 ist diejenige Menge, die abgetragen wird, wenn die Metallschmelze 32 dieselbe stoffliche Beschaffenheit besitzt, wie die Kohtakthöcker. Besitzt sie eine andere stoffliche Beschaffenheit, ist das gesamte Volumen der Kontakthöcker 25 von Figur 1 durch Schmelzen abgetragen.

Ein weiteres Beispiel der Bereitstellung einer alternativen Metallschmelze zeigt die **Figur 5**. Hier ist ein Schwallbad 31 gezeichnet, das entlang eines in der Aufsicht streifenförmigen Bereiches eine kontinuierliche Bewegung besitzt, die das im Innern des Behälters 29 vorgesehene Metallbad 30 erfährt. Der so erhaben von der übrigen Oberfläche des Metallbades ausgebildete Schwallrücken dient als Abschmelzbereich für ein horizontal darüber bewegtes Substrat 10, das gemäß Figur 6 entlang der Bewegung v1 zum Schwall 31 hin bewegt wird. Die auf dem Schwall 31 liegende Hilfsschicht 40 wird später erläutert werden und soll zunächst für die Beschreibung des Abschmelzens unberücksichtigt bleiben.

Die Bewegung v1 ist so langsam, daß die Schwallbreite ausreicht, das Abschmelzen der fehlerhaften Kontakthöcker 11,12 homogen zu erreichen und nach dem Herübergleiten des Substrates 10 dieselbe Oberfläche zu ergeben, die auch Figur 3 als Verfahrensergebnis der Figur 4 gezeigt hat.

Gegenüber der Figur 4 wird beim Verfahren gemäß **Figur 5 und 6** der gesamte Bestand an Kontakthöckem, unabhängig davon, ob sie fehlerhaft oder ordnungsgemäß gebildet sind, zeitlich nacheinander abgetragen. Beim Beispiel der Figur 4 wurden sämtliche Kontakthöcker durch Berühren der Oberfläche 32 praktisch zeitgleich abgeschmolzen, nur zeitlich dadurch unterschiedlich, daß eine unterschiedliche Höhe der Kontakthöcker einen geringfügig späteren Zeitpunkt der Berührung mit der Oberfläche 32a ergibt. Sinngemäß ist das als gleichzeitig zu bezeichnen, während die horizontale Bewegung zu einem streifenförmigen Abschmelzen der Kontakthöcker entlang der Oberfläche 10a des Substrates 10 führt, unter Belassen der meniskenartigen Hauben 60 auf den Trägersegmenten 9 des Substrates 10.

**Figur 6a** zeigt eine vorteilhaftes Ergänzung des Substrates 10 nach Figur 6. Hier ist eine zusätzliche Fluidschicht 41 als Film über die Kontaktstrukturen 11,12,13, die Trägersegmente 9 und die Substratoberfläche 10a gelegt. Die Stärke dieses Films 41 ist als dünne Schicht mit d bezeichnet. Sie entspricht im wesentlichen der Höhe der Kontakthöcker 11, kann aber auch so ausgestaltet sein, daß die Kontakthöcker nur in den Zwischenbereichen mit der Schicht 41 ausgefüllt sind.

Die Fluidschicht 41 entspricht in ihrer Konsistenz der alternativ oder kumulativ vorgesehenen Fluidschicht 40 von Figur 5. Sie besteht aus einem Polyalkohol, insbesondere Glyzerin, das einen Siedepunkt von 290°C besitzt und oberhalb derjenigen ersten Temperaturgrenze liegt, die benötigt wird, um die Kontakthöcker von den Trägersegementen 9 abzuschmelzen.

Aufgrund der nur dünnen vorgesehenen Schicht wird wenig Volumen eines solchen Fluides als Verfahrens-Hilfsstoff benötigt. Vor allen Dingen wird bei einer Temperatur im Bereich der Schmelztemperatur des Lotes und einer dünnen Ausbildung als Film erreicht, daß dieser Film nach der Berührung mit der Metallschmelze 31 verdampft. Ein Verdampfen läßt einen weiteren Reinigungsschritt entfallen. Das in Figur 3 gezeigte Oberflächenprofil und auch die Oberflächenstruktur bildet bereits die erneut mit Metallhöckern versehbare Oberfläche, ohne daß ein Reinigungsschritt erst den Verfahrens-Hilfsstoff entfernen muß. Der Hilfsstoff hat auch für das Ablösen eine begünstigende Wirkung, nachdem er von sich aus die Einschnürung beim Abschmelzen begünstigt und auch die Meniskenbildung gemäß Figur 3 vergleichmäßigt. Alternative Substanzen für Glyzerin sind ein Paraffin-Wachs oder andere im eingangs zitierten Stand der Technik angesprochene Stoffe.

Das Substrat 10 mit der filmartigen Belegung gemäß Figur 6a kann auch in Verbindung mit Figur 4 eingesetzt werden.

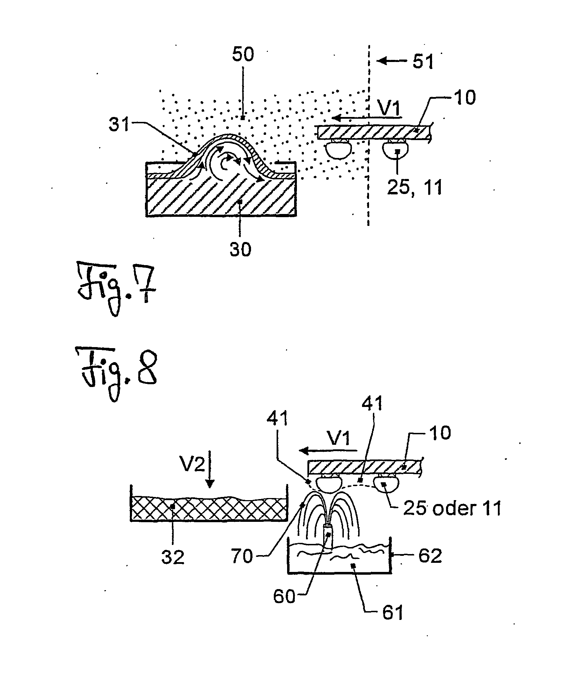

Die Entstehung der Filmbildung soll an den **Figuren 7 und 8** beschrieben werden. In diesen Figuren wird schematisch das Substrat 10 gezeigt, wie es in einen Atmosphärenbereich 50 ab der vertikalen Schrankenebene 51 eintritt, welche dafür sorgt, daß eine Filmbildung auf der Seite 10a des Substrates 10 entsteht, auf der die erhabenen Kontakthöcker 11,25 (als Beispiele derjenigen Kontakthöcker aus Figuren 1,2) schematisch skizziert sind. Die Atmosphäre sorgt zwar auch dafür, daß die abgewandte Seite des Substrates mit einer solchen Filmschicht belegt wird, was aber für das Abschmelzen in dem aus Figur 5 vorgesehenen Schwallbad 31 mit einer Metallschmelze 30 unkritisch ist.

Die Grenze 51 kann nach links oder rechts verschoben werden. Das Beschichten des Substrats mit seiner Oberfläche 10a auf der Seite der Kontaktstrukturen erfolgt entweder vor der Berührung der Metallschmelze 31, oder gleichzeitig damit. Die Verwendung einer Gasphase 50 sorgt trotz eines geringen Volumens des beschriebenen Fluids für eine gleichmäßige Bedeckung der gezeichneten Strukturen.

Aus **Figur 8** ist eine alternative Beschichtung durch ein Besprühen der Kontaktstrukturen 25,11 auf dem Substrat 10 ersichtlich. Eine Fontäne 70 aus einem Aufstiegsrohr 60 und einem Fluidsumpf 61 in einer Wanne 62 sorgt für die Ausbildung der filmartigen Belegung 41 der Oberfläche der Kontaktstrukturen. Sie werden hier in ein Metallbad gemäß Figur 4 durch eine kombinatorische Horizontal- und Vertikalbewegung v1,v2 eingeführt, wobei alle Metallhöcker gleichzeitig abgeschmolzen werden. Ebenfalls abgeschmolzen im Sinne eines Verdampfens wird die dünne Schicht 41.

## Patentansprüche

1. **Verfahren zum Abtragen** einer Vielzahl von erhabenen, zum Kontaktieren über ihre Oberflächen vorgesehenen und ausgebildeten
Kontaktbumps (11,12,13,17,18) aus - oberhalb einer ersten Temperaturgrenze - schmelzfähigem Metall, wie Zinn oder Indium, oder einer solchen Legierung, wie zinnhaltiges Lot, siberhaltiges Lot oder bleihaltiges Lot, welche Kontaktbumps auf einem ersten Substrat (10) flächig verteilt angeordnet sind, und weiches Substrat im Bereich der ersten Temperaturgrenze nicht schmilzt;
***dadurch gekennzeichnet, dass***
eine Vielzahl der erhabenen Kontaktbumps (11,12), insbesondere im wesentlichen alle, durch eine Berührung mit einem geschmolzenen Metall (30,31,32), insbesondere einer solchen Legierung, von dem ersten Substrat (10) in zumindest wesentlichen Anteilen abgeschmolzen werden.

2. Verfahren nach Anspruch 1, wobei sich zwischen den erhabenen
Kontaktbumps (11,12,13) und dem ersten Substrat (10) flächig begrenzte metallische Trägersegmente (9) befinden, deren Schmelztemperatur oberhalb der ersten Temperaturgrenze liegt, um ihre Anwesenheit auf dem Substrat nach dem Abschmelzen zumindest wesentlicher Bestandteile der erhabenen Kontaktbumps zu sichern.

3. Verfahren nach Anspruch 2, wobei nach dem Abschmelzen der erhabenen Kontaktbumps (11,12,13) auf den am Substrat verbleibenden Trägersegmenten (9) haubenförmige Metallschmelzen (60) verbleiben, die nach dem Erkalten, insbesondere Erstarren, die Oberfläche der Trägersegmente vergleichmäßigende, gewölbte Hauben (60) bilden, weiche im wesentlichen aus dem zum Abschmelzen verwendeten Metall (30,31,32) bestehen.

4. Verfahren nach Anspruch 1, wobei die zum Abschmelzen verwendete Metall-Legierung im wesentlichen dieselbe ist, wie die Metall-Legierung der erhabenen Kontaktbumps.

5. Verfahren nach Anspruch 1, wobei das zum Abschmelzen verwendete flüssige Metall im wesentlichen dasselbe Metall ist, wie dasjenige der abzuschmelzenden erhabenen **Kontaktbumps** (11,12,13,14).

6. Verfahren nach Anspruch 1, wobei die erhabenen Kontaktbumps zumindest teilweise ungleichmäßig (17,18), insbesondere für eine elektrische Kontaktierung zumindest teilweise ungeeignet sind.

7. Verfahren nach Anspruch 1, wobei die erhabenen Kontaktbumps eine für das Substrat (10) nicht gewünschte stoffliche Beschaffenheit aufweisen, die mit dem Stoff als Metall oder Metall-Legierung ersetzt wird, welcher dem zum Abschmelzen verwendeten Metall/Legierung entspricht, so daß ein Stoffaustausch erfolgt.

8. Verfahren nach Anspruch 1, wobei die Berührung durch ein zumindest berührendes Eintauchen in ein Metallbad (32) erfolgt, und die erhabenen Kontaktbumps (11, 12) und das Bad mit einer Relativbewegung (v2) einander angenähert werden, um das geschmolzene Metall mit den Kontaktbumps in Berührung zu bringen, wobei alle abzutragenden erhabenen Kontaktbumps im wesentlichen gleichzeitig abgeschmolzen werden.

9. Verfahren nach Anspruch 8, wobei die Relativbewegung (v2) zumindest bis zu einer Berührung von Badoberfläche (32a) mit flächig begrenzten Trägersegmenten (9) auf dem Substrat (10) reicht, insbesondere bis zu einer Berührung der Badoberfläche und der dem Bad zugewandten Oberfläche (10a) des Substrates.

10. Verfahren nach Anspruch 9, wobei sich eine Verweilzeit anschließt und daran eine entgegengesetzt gerichtete Relativbewegung (v2') anschließt, mit der das Bad und das Substrat getrennt werden.

11. Verfahren nach Anspruch 1, wobei das geschmolzene Metall, insbesondere als geschmolzene Metall-Legierung (30) ein zumindest in einem Streifenbereich in Bewegung gehaltenes Metallbad (31) ist, insbesondere als Schwallbad.

12. Verfahren nach Anspruch 11, wobei die erhabenen Kontaktbumps (11,12,13) im wesentlichen parallel zur Oberfläche des Metallbades (31), relativ zu dem Metallbad bewegt werden (v1) und die flächig verteilten, erhabenen Kontaktbumps zeitlich nacheinander abgeschmolzen werden.

13. Verfahren nach Anspruch 12 oder 8, wobei die Geschwindigkeit der Bewegung (v1,v2) so gewählt ist, daß sie jedem Trägersegment (9) auf dem Substrat eine Mindestverweilzeit im Bad (32) oder im Streifenbereich des bewegten Metallbades (31) erlaubt, die ein Abschmelzen der jeweils zugehörigen, ggf. fehlerhaften erhabenen Kontaktbumps (11,12,13) zur Folge hat.

14. Verfahren nach Anspruch 1, wobei das Substrat (10) zur Einbindung der erhabenen Kontaktbumps nur eine Schicht (41) aus einem organischen Fluid, insbesondere einem Polyalkohol wie Glyzerin trägt, bevor die erhabenen Kontaktbumps mit dem geschmolzenen Metall, insbesondere durch eine horizontale Relativbewegung nach Anspruch 12 oder eine vertikale Relativbewegung nach Anspruch 8, in Berührung kommen.

15. Verfahren nach Anspruch 14, wobei das Fluid einen Siedepunkt besitzt, der oberhalb der ersten Temperaturgrenze liegt.

16. Verfahren nach Anspruch 14, wobei die Fluidschicht (41) durch Aufsprühen oder durch Aufdampfen auf die Oberfläche (10a) des Substrats aufgetragen wird, auf der sich die abzutragenden Kontaktbumps (11,12,13) befinden.

17. Verfahren nach Anspruch 14, wobei die abdeckende Schicht (41) eine Dicke besitzt (d), die maximal der doppelten Höhe der erhabenen Kontaktbumps entspricht, insbesondere die Dicke der Fluidschicht geringer ist als eine Dicke des Substrats (s) oder im wesentlichen der Höhe der erhabenen Kontaktbumps (d) entspricht.

18. Verfahren nach Anspruch 14 oder 17, wobei die Fluidschicht (41) nach dem Abschmelzen der erhabenen Kontaktbumps im wesentlichen verdampft ist.

19. Verfahren nach Anspruch 17 oder 14, wobei die Fluidschicht (41) als dünne Schicht mit Bezug zum Substrat zu bezeichnen ist.

20. Verfahren nach Anspruch 1, wobei auf der Oberfläche (31) eines in Bewegung gehaltenen Metallbades (30) nach Anspruch 11 oder eines Metallbades (32) nach Anspruch 8 eine demgegenüber nur dünne Schicht (40) aus einem noch nicht verdampfenden organischen Fluid liegt, entsprechend demjenigen Fluid des Anspruchs 14.

21. Verfahren nach Anspruch 1, wobei das Berühren der erhabenen Kontaktbumps mit der Metallschmelze (31,32) in einer Atmosphäre aus einem verdampften organischen Fluid (50) erfolgt.

## Claims

1. Process for removing a plurality of raised contact bumps (11, 12, 13, 17, 18) provided and designed for contacting via their surfaces and made from metal which can be melted - above a first temperature limit - such as tin or indium, or an alloy, such as tin-containing solder, silver-containing solder or lead-containing solder, which contact bumps are arranged distributed two-dimensionally on a first substrate (10), and which substrate does not melt in the region of the first temperature limit; **characterised in that** a plurality of raised contact bumps (11, 12), in particular essentially all, are melted off from the first substrate (10) in at least considerable proportions by contact with a molten metal (30, 31, 32), in particular such an alloy.

2. Process according to claim 1, wherein two-dimensionally defined metallic support segments (9) are situated between the raised contact bumps (11, 12, 13) and the first substrate (10), the melting temperature of which support segments (9) lies above the first temperature limit in order to secure their presence on the substrate after melting off of at least considerable constituents of the raised contact bumps.

3. Process according to claim 2, wherein after melting off the raised contact bumps (11, 12, 13), dome-like metal melts (60) remain on the support segments (9) remaining on the substrate, which metal melts (60) after cooling, in particular solidifying, form vaulted domes (60) which homogenise the surface of the support segments and consist essentially of the metal (30, 31, 32) used for melting off.

4. Process according to claim 1, wherein the metal alloy used for melting off is essentially the same as the metal alloy of the raised contact bumps.

5. Process according to claim 1, wherein the liquid metal used for melting off is essentially the same metal as that of the raised contact bumps (11, 12, 13, 14) to be melted off.

6. Process according to claim 1, wherein the raised contact bumps are at least partly non-uniform (17, 18), in particular at least partly unsuitable for electrical contacting.

7. Process according to claim 1, wherein the raised contact bumps have a material quality which is not desirable for the substrate (10), and is replaced by the material as metal or metal alloy, which corresponds to the metal/alloy used for melting off, so that mass transfer takes place.

8. Process according to claim 1, wherein contact takes place by at least contacting immersion in a metal bath (32), and the raised contact bumps (11, 12) and the bath approach one another with a relative movement (v2) in order to bring the molten metal into contact with the contact bumps, wherein all raised contact bumps to be removed are essentially melted off at the same time.

9. Process according to claim 8, wherein the relative movement (v2) extends at least as far as contact of bath surface (32a) with two-dimensionally defined support segments (9) on the substrate (10), in particular as far as contact of the bath surface and the surface (10a) of the substrate facing the bath.

10. Process according to claim 9, wherein a residence time follows and after that a relative movement (v2') in the opposite direction follows, with which the bath and the substrate are separated.

11. Process according to claim 1, wherein the molten metal, in particular as molten metal alloy (30), is a metal bath (31) kept in motion at least in a strip region, in particular as a surge bath.

12. Process according to claim 11, wherein the raised contact bumps (11, 12, 13) are moved (v1) essentially parallel to the surface of the metal bath (31), relative to the metal bath, and the two-dimensionally distributed, raised contact bumps are melted off one after another in time.

13. Process according to claim 12 or 8, wherein the speed of the movement (v1, v2) is selected so that it allows each support segment (9) on the substrate a minimum residence time in the bath (32) or in the strip region of the moved metal bath (31), which results in melting off of the particular associated optionally faulty raised contact bumps (11, 12, 13).

14. Process according to claim 1, wherein the substrate (10) carries only one layer (41) of an organic fluid, in particular a polyalcohol, such as glycerol, for integrating the raised contact bumps, before the raised contact bumps come into contact with the molten metal, in particular due to a horizontal relative movement according to claim 12 or a vertical relative movement according to claim 8.

15. Process according to claim 14, wherein the fluid has a boiling point which lies above the first temperature limit.

16. Process according to claim 14, wherein the fluid layer (41) is applied by spraying or by evaporation coating onto the surface (10a) of the substrate, on which the contact bumps (11, 12, 13) to be removed are situated.

17. Process according to claim 14, wherein the covering layer (41) has (d) a thickness, which corresponds to double the height of the raised contact bumps maximum, in particular the thickness of the fluid layer is lower than the thickness of the substrate (s) or essentially corresponds to the height of the raised contact bumps (d).

18. Process according to claim 14 or 17, wherein the fluid layer (41) is essentially evaporated after melting off the raised contact bumps.

19. Process according to claim 17 or 14, wherein the fluid layer (41) can be designated as a thin layer with reference to the substrate.

20. Process according to claim 1, wherein an only comparatively thin layer (40) of a not yet evaporating organic fluid, corresponding to that fluid of claim 14, lies on the surface (31) of a metal bath (30) kept in motion according to claim 11 or a metal bath (32) according to claim 8.

21. Process according to claim 1, wherein contacting of the raised contact bumps with the metal melt (31, 32) takes place in an atmosphere of an evaporated organic fluid (50).

## Revendications

1. Procédé d'élimination d'une pluralité de bossages de contact saillants (11,12,13,17,18) prévus et conformés pour venir en contact via leurs surfaces en métal fusible - au-dessus d'une première limite de température - comme l'étain ou l'indium, ou dans un alliage tel qu'un alliage d'apport contenant de l'étain, un alliage d'apport contenant de l'argent ou un alliage d'apport contenant du plomb, lesquels bossages de contact sont disposés répartis en surface sur un premier substrat (10), ledit substrat ne fondant pas dans la plage de la première limite de température, **caractérisé en ce qu'**une pluralité des bossages de contact saillants (11,12), en particulier sensiblement tous, sont enlevés du premier substrat (10) par fusion par contact avec un métal fondu (30,31,32), en particulier avec un tel alliage, dans des proportions au moins sensibles.

2. Procédé selon la revendication 1, dans lequel il y a entre les bossages de contact saillants (11,12,13) et le premier substrat (10) des segments porteurs métalliques limités en surface (9), dont la température de fusion est supérieure à la première limite de température afin d'assurer leur présence sur le substrat après l'élimination par fusion de composants au moins essentiels des bossages de contact saillants.

3. Procédé selon la revendication 2, dans lequel, après élimination par fusion des bossages de contact saillants (11,12,13), il reste sur les segments porteurs (9) restant sur le substrat des masses métalliques fondues (60) en forme de masselottes, qui forment, après refroidissement, en particulier après solidification, des masselottes bombées (60) égalisant la surface des segments porteurs et qui sont essentiellement constituées du métal utilisé pour l'élimination par fusion (30,31,32).

4. Procédé selon la revendication 1, dans lequel l'alliage métallique utilisé pour l'élimination par fusion est essentiellement le même que l'alliage métallique des bossages de contact saillants.

5. Procédé selon la revendication 1, dans lequel le métal liquide utilisé pour l'élimination par fusion est en substance le même métal que celui des bossages de contact saillants (11,12,13,14) à éliminer par fusion.

6. Procédé selon la revendication 1, dans lequel les bossages de contact saillants sont au moins en partie inégaux (17,18), en particulier au moins en partie inappropriés pour établir un contact électrique.

7. Procédé selon la revendication 1, dans lequel les bossages de contact saillants présentent une structure matérielle non souhaitée pour le substrat (10), qui est remplacée par le matériau (sous la forme de métal ou d'alliage métallique) qui correspond au métal ou à l'alliage utilisé pour l'élimination par fusion de sorte qu'il se fasse un échange de matériaux.

8. Procédé selon la revendication 1, dans lequel le contact s'effectue par une immersion faisant au moins contact dans un bain métallique (32) et les bossages de contact saillants (11,12) et le bain sont rapprochés l'un de l'autre par un mouvement relatif (v2) afin de mettre le métal fondu en contact avec les bossages de contact, tous les bossages de contact saillants à éliminer l'étant par fusion sensiblement en même temps.

9. Procédé selon la revendication 8, dans lequel le mouvement relatif (v2) parvient au moins jusqu'à un contact de la surface (32a) du bain avec des segments porteurs limités en surface (9) sur le substrat (10), en particulier jusqu'à un contact de la surface du bain et de la surface (10a) du substrat tournée vers le bain.

10. Procédé selon la revendication 9, dans lequel il s'ensuit un temps de séjour auquel succède un mouvement relatif (v2') dirigé en sens inverse, qui sépare le bain et le substrat.

11. Procédé selon la revendication 1, dans lequel le métal fondu, en particulier sous la forme d'un alliage de métal fondu (30), est un bain métallique (31) maintenu en mouvement au moins dans une zone en bande, en particulier sous la forme d'un bain de brasage.

12. Procédé selon la revendication 11, dans lequel les bossages de contact saillants (11,12,13) sont déplacés (v1) par rapport au bain métallique (31) en substance parallèlement à la surface du bain métallique et en ce que les bossages de contact saillants répartis en surface sont successivement éliminés par fusion.

13. Procédé selon la revendication 12 ou 8, dans lequel la vitesse du mouvement (v1, v2) est choisie de sorte qu'elle permette à chaque segment porteur (9) sur le substrat un temps de séjour minimal dans le bain (32) ou dans la zone en bande du bain métallique déplacé (31), ce qui a pour conséquence une élimination par fusion des bossages de contact saillants respectivement associés, éventuellement défectueux (11,12,13).

14. Procédé selon la revendication 1, dans lequel le substrat (10) porte seulement une couche (41) d'un fluide organique, en particulier d'un polyalcool comme la glycérine, pour la liaison des bossages de contact saillants avant que les bossages de contact saillants ne viennent en contact avec le métal fondu, en particulier par un mouvement relatif horizontal selon la revendication 12 ou un mouvement relatif vertical selon la revendication 8.

15. Procédé selon la revendication 14, dans lequel le fluide possède un point d'ébullition qui se situe au-dessus de la première limite de température.

16. Procédé selon la revendication 14, dans lequel la couche de fluide (41) est appliquée par pulvérisation ou par métallisation sur la surface (10a) du substrat sur laquelle se trouvent les bossages de contact à éliminer (11,12,13).

17. Procédé selon la revendication 14, dans lequel la couche couvrante (41) possède une épaisseur (d) qui correspond au maximum à la double hauteur des bossages de contact saillants, en particulier l'épaisseur de la couche de fluide étant inférieure à une épaisseur du substrat (s) ou correspond sensiblement à la hauteur des bossages de contact saillants (d).

18. Procédé selon la revendication 14 ou 17, dans lequel la couche de fluide (41) est sensiblement vaporisée après l'élimination par fusion des bossages de contact saillants.

19. Procédé selon la revendication 17 ou 14, dans lequel on peut qualifier la couche de fluide (41) de couche mince par rapport au substrat.

20. Procédé selon la revendication 1, dans lequel, sur la surface (31) d'un bain métallique (30) maintenu en mouvement selon la revendication 11 ou d'un bain métallique (32) selon la revendication 8, il y a une couche (40) seulement mince par rapport au bain et qui est formée d'un fluide organique ne se vaporisant pas encore et correspondant au fluide de la revendication 14.

21. Procédé selon la revendication 1, dans lequel le contact des bossages de contact saillants avec la masse fondue métallique (31,32) s'effectue dans une atmosphère de fluide organique vaporisé (50).
